# EUROPÄISCHE PATENTANMELDUNG

(11) **EP 3 599 804 A1**
(43) Veröffentlichungstag der Anmeldung: **29.01.2020**
(21) Anmeldenummer: 19185497.5
(22) Anmeldetag: 10.07.2019
(51) Int. Cl.: H05K 5/02

(54) **STEUERGERÄT MIT EINSETZBAREM FUNKMODUL, SOWIE FUNKMODUL, DECKEL UND STECKER**

(30) Priorität: 17.07.2018 DE 102018211857
(71) Anmelder: Robert Bosch GmbH, 70442 Stuttgart (DE)
(72) Erfinder: Genise, Marco, 97877 Wertheim (DE); Meisselbach, Alexander, 97794 Rieneck (DE); Kison, Thomas, 97737 Gemuenden (DE); Neumann, Joachim, 97816 Lohr (DE)

(57) **Zusammenfassung**

Offenbart ist ein elektronisches Steuergerät mit einem Gehäuse (2, 8), wobei ein Funkmodul (16), wie ein Bluetooth-Modul, in eine Öffnung (10) des Gehäuses (2, 8) einsetzbar und vorzugsweise wieder entnehmbar ist. Ferner ein in die Öffnung (10) einsetzbares Funkmodul (16), ein darin einsetzbarer Deckel (12) und ein darin einsetzbarer Stecker.

## Beschreibung

Die Erfindung betrifft ein Steuergerät gemäß dem Oberbegriff des Anspruchs 1, sowie ein Funkmodul gemäß dem Oberbegriff des Anspruchs 10, einen Deckel gemäß dem Oberbegriff des Anspruchs 13 und einen Stecker gemäß dem Oberbegriff des Anspruchs 16.

Aus der EP 1 881 249 A1 ist eine Ventilbaugruppe mit einer Anzeigevorrichtung für Ventilinformationen bekannt. Die Ventilbaugruppe ist mit einer Datenübertragungseinrichtung zur Übertragung der Ventilinformationen an ein tragbares Endgerät mit der Anzeigevorrichtung versehen. Die Datenübertragungseinrichtung ist gemäß einer Ausführungsform als ein Sendemodul zur drahtlosen Übertragung, insbesondere für Funk-, Infrarot- oder Bluetooth-Signale, ausgebildet. Dabei kann das Sendemodul in ein Elektronikmodul integriert sein, oder das Sendemodul und das Elektronikmodul sind separat ausgebildet, beispielsweise endseitig an der Ventilbaugruppe angeordnet. Die Datenübertragungseinrichtung besitzt gemäß einer anderen Ausführungsform ein Datenübertragungskabel zur drahtgebundenen Übertragung.

Ein Anwender ist somit dahingehend eingeschränkt, dass er sich für ein Elektronikmodul ohne Sendemodul oder für ein Elektronikmodul mit integriertem Sendemodul zum drahtlosen Übertragen oder für ein Elektronikmodul mit integriertem Sendemodul zum drahtgebundenen Übertragen entscheiden muss. Sofern sich der Anwender für ein separates Sendemodul entscheidet, ist er bauraumlich eingeschränkt.

Die Aufgabe der vorliegenden Erfindung besteht darin, eine flexibel anwendbare Datenübertragung für ein Steuergerät vorzusehen. Besonderes Augenmerk liegt auf Aspekten der Serienfertigung und/oder Fluidtechnik-üblichen Erfordernissen, wie einer hohen Individualisierung des Produkts.

Diese Aufgabe wird gelöst durch ein elektronisches Steuergerät mit den Merkmalen des Patentanspruchs 1, ein Funkmodul mit den Merkmalen des Anspruchs 10, einen Deckel mit den Merkmalen des Anspruchs 13 und einem Stecker mit den Merkmalen des Anspruchs 16.

Ein erfindungsgemäßes Steuergerät weist eine Steuerelektronik zum Ansteuern eines Steuerungsobjekts, insbesondere eines Hydraulikventils, besonders bevorzugt eines Druckventils und/oder Wegeventils, auf. Beispielsweise kann die Steuerelektronik zumindest einen elektronischen Regler, zumindest einen elektronischen Verstärker und/oder zumindest eine andere elektronische Komponente umfassen. Die Steuerelektronik ist in einem Gehäuse angeordnet geschützt. Indem zumindest ein Funkmodul in zumindest eine Öffnung des Gehäuses unter Herstellen einer elektrischen Verbindung einsetzbar ist, kann ein passendes Modul, wie eben kein Modul, das Funkmodul oder ein Stecker, flexibel gewählt werden. Gleichzeitig ist das gewählte Modul einem integrierten Modul ähnlich mit Vorteil durch das Gehäuse geschützt, und vorteilhaft elektrisch kurz angebunden. Die Öffnung findet sich an einer bevorzugt freien Seite des Gehäuses, wie einer Ober-, Unter-, Vorder-, Rück- oder lateralen Seite. Unter einem Einsetzten kann hierbei auch ein Einbringen, ein Einlegen, ein Einstecken und/oder ein anderweitiges Montieren verstanden werden. Weiterbildend kann das Funkmodul in die Öffnung eingepasst sein, um einen vibrationsfesten Sitz zu erreichen.

Ist das Funkmodul aus der Öffnung wieder entnehmbar, wie herausnehmbar, aussteckbar und/oder demontierbar, erhält ein Anwender einerseits ein mehrfach flexibles Steuergerät, da er das passende Modul noch flexibler situationsbezogen wählen kann. Andererseits kann der Anwender Kosten-sparend das Steuergerät und/oder das gewählte Modul mehrfach verwenden. Insofern ist ein Entnehmen unter besonders bevorzugt zerstörungsfreiem bzw. reversiblem Trennen der elektrischen Verbindung bevorzugbar. Ein Entnehmen eines Funkmoduls kann eine Sicherheit gegen unbefugtes Eindringen, fachsprachlich Hacken, erhöhen.

Gemäß einer Weiterentwicklung der Erfindung weist das Steuergerät durch die Öffnung kontaktierbare Kontaktflächen auf, sodass die elektrische Verbindung mechanisch zuverlässig und einfach herstellbar ist. Die Kontaktflächen sind zum Herstellen der elektrischen Verbindung (d.h. zwischen dem Funkmodul und der Steuerelektronik) konfiguriert. Vorzugsweise sind sie zur Datenübertragung, wie besonders bevorzugt zur seriellen und/oder parallelen Datenübertragung, und/oder zur Strom- und/oder Spannungsversorgung konfiguriert und/oder ausgelegt, wie dimensioniert und/oder beschichtet. Die Kontaktflächen sind beispielsweise durch die Öffnung kontaktierbar, wenn sie zu der Öffnung ausgerichtet, etwa zu einer Achse der Öffnung radial und/oder axial orientiert sind. Gemäß einem Ausführungsbeispiel ist zumindest ein Träger, wie eine Platine, beispielsweise eine gedruckte Leiterplatte, in Verlängerung der Achse der Öffnung angeordnet, an dessen Oberseite zumindest ein Teil der Kontaktflächen zugänglich angeordnet ist. Weiterbildend sind die Kontaktflächen am Boden der Öffnung bzw. an einem einer Mündung der Öffnung abgewandten axialen Ende der Öffnung angeordnet, wobei bevorzugt die Kontaktflächen als ein Widerlager zur Anlage des Funkmoduls platziert sind, um eine Vibrationssicherheit und eine Kontaktsicherheit zu erhöhen.

Die Kontaktflächen können beispielsweise als Ringsegmente bzw. auf zumindest einer Kreisbahn angeordnete gebogen-längliche Abschnitte ausgeführt sein oder solche Abschnitte umfassen. In einem begrenzten Bereich lässt sich dadurch eine rotatorische Bewegung des Funkmoduls gegenüber der Öffnung ermöglichen, beispielsweise zugunsten einer drehenden Montage und/oder einer Lagetoleranz. Eine vorbestimmte Winkelposition des Funkmoduls in einer Endlage kann beispielsweise durch eine Kulissenführung oder dergleichen reproduzierbar und konstruktiv erreicht werden.

Gemäß eines weiteren Ausführungsbeispiels ist eine Kontaktplatte in einer Ausnehmung des Gehäuses ausgebildet, die als durchgehende Kontaktfläche konfigurierbar ist. Die Kontaktplatte ist über ein Anschlusskabel mit einem Inneren des Gehäuses verbunden, wobei ein Durchbruch für das Anschlusskabel zwischen der Ausnehmung und dem Inneren derart ausgebildet ist, dass ausschließlich das Anschlusskabel hindurch passt, seine Dimensionierung also minimal klein ist.

Ein besonders geschütztes Gehäuse ist zumindest abschnittsweise aus einem metallischen Werkstoff, wie einer Legierung, gebildet. Um eine Funkverbindung unmittelbar durch ein eingesetztes Funkmodul, also kostensparend ohne separate Antenne, zu ermöglichen, kann zumindest ein an einen Einbauraum für das Funkmodul angrenzender Abschnitt zumindest ein funkwellendurchlässiges Material enthalten oder vorzugsweise daraus bestehen. Eine besonders günstige Funkwellenausbreitung ergibt sich, wenn das funkwellendurchlässige Material den Einbauraum etwa hemisphärisch umgibt. So kann / können gemäß einer Ausführungsform die Öffnung und/oder der Einbauraum durch eine an dem bevorzugt metallischen Grund-Gehäuse festgelegte Kappe definiert werden, sodass die Kappe einen Gehäuseteil bildet. Eine kostengünstige Ausführung ist eine Kunststoffkappe, also eine aus einem Kunststoff hergestellte Kappe. Die Kappe kann beispielsweise außen kegelstumpfförmig und/oder innen hohlzylindrisch geformt sein. Wenn in einer bevorzugten Ausführungsform das Funkmodul in der Kappe außerhalb des metallenen Gehäuseteils angeordnet ist, kann eine besonders wenig behinderte Abstrahlung erreicht werden.

Gemäß einer Weiterbildung ist an der Öffnung, beispielsweise konzentrisch zu dieser, ein zum Arretieren eines Einsetzteils bzw. des Funkmoduls konfigurierter Drehverschluss vorgesehen. Der Drehverschluss kann beispielsweise ein Schraubverschluss oder ein Bajonettverschluss sein. Mit Vorteil kann der Drehverschluss zum Verbinden mit und Verschließen der Öffnung, wie der / mit der Kappe, konfiguriert sein.

Besonders bevorzugt ist das Steuergerät zum Einsetzten eines Funkmoduls nach einem Funkstandard, insbesondere einem Nahbereichsfunkstandard, besonders bevorzugt einem Bluetooth-Standard, konfiguriert. So können beispielsweise eine Strom-/Spannungsversorgung des Funkmoduls, die Einbauraumgröße, eine Wärmeabführung, eine elektromagnetische Verträglichkeit der übrigen Elektronik und/oder insbesondere eine Funkwellendurchlässigkeit entsprechend ausgelegt sein.

Unabhängig beanspruchbar ist auch ein Funkmodul für ein Steuergerät, welches zum Eingesetzt-Werden in die Öffnung des vorbeschriebenen Steuergeräts unter Herstellen der elektrischen Verbindung, und vorzugsweise auch zum vorbeschriebenen bevorzugt zerstörungsfreien Wieder-Entnommen-Werden aus der Öffnung, konfiguriert ist. Ein erfindungsgemäßes Funkmodul ist also ein Einsetzteil. Das Funkmodul ist flexibel verwendbar, situationsadäquat auswählbar und bevorzugt kostensparend wiederverwendbar.

Das Funkmodul ist vorzugsweise nach einem Funkstandard, insbesondere einem Nahbereichsfunkstandard, besonders bevorzugt einem Bluetooth-Standard, konfiguriert. Dies ermöglicht eine einfach umsetzbare Verbindung zu einem Übertragungspartner, wie einem Auslese- und/oder Schreib- bzw. Konfiguriergerät.

Entsprechend zu dem Steuergerät enthält das Funkmodul gemäß einer Weiterentwicklung zu den Kontaktflächen des vorbeschriebenen Steuergeräts korrespondierende Kontaktelemente, also Kontaktelemente, welche bezüglich ihrer Position, Anzahl, Dimensionierung und/oder Werkstoffwahl zu den Kontaktflächen des Steuergeräts gegengleich sind. Die Kontaktelemente können mit Vorteil zur ausgleichenden Anlage an die Kontaktflächen vorgespannt teleskopierbare Federstifte sein, sodass eine mechanisch sichere elektrische Verbindung eine stabile Datenübertragung gewährleistet. Die Federstifte können zur Datenübertragung, bevorzugt zur seriellen und/oder parallelen Datenübertragung, und/oder zur Strom- und/oder Spannungszufuhr konfiguriert sein. Gemäß einem Ausführungsbeispiel sind die Kontaktelemente an einer Unterseite des Funkmoduls, also an einer in Einbaulage von der Öffnung abgewandten Seite, platziert. Gemäß einem umgekehrten Ausführungsbeispiel können die "Kontaktflächen" des Steuergeräts derartige Federstifte sein, und können die "Kontaktelemente" dazu korrespondierende Anlageflächen sein. Die Federstifte sollten zum Kontaktieren zumindest in Einbaulage bemessen sein.

Gemäß einem weiteren Ausführungsbeispiel ist das Funkmodul auf einem kreisförmigen Träger ausgebildet. Dabei ist der Träger derart dimensioniert, dass er in die Öffnung des Gehäuses bzw. der Kappe einbringbar ist.

Im Übrigen ist die Beschreibung des Steuergeräts auf das Funkmodul, wie auch auf die folgenden Einsetzteile, anwendbar; die beschriebenen Elemente sind also zueinander jeweils kompatibel.

Unabhängig beanspruchbar ist auch ein Deckel, welcher zum dichtenden Verschließen, insbesondere zum Abdichten gegen Umwelteinflüsse, der Öffnung eines vorbeschriebenen Steuergeräts ausgebildet ist. Dadurch ist das Öffnungs-Innere bzw. Gehäuse-Innere als ein Bauraum für Elektronik beispielswiese vor Staub, Feuchtigkeit oder anderen störenden Einflüssen schützbar. Der Deckel ist also ein Einsetzteil.

Der erfindungsgemäße Deckel kann ein erfindungsgemäßes Funkmodul enthalten, bzw. das erfindungsgemäße Funkmodul kann als ein erfindungsgemäßer Deckel ausgestaltet sein. Bei dieser Ausführungsform sind die Vorteile des Funkmoduls und des Deckels synergetisch kombiniert.

Alternativ können der erfindungsgemäße Deckel und das erfindungsgemäße Funkmodul voneinander unabhängig sein, sodass diese unkompliziert gegenseitig unbeeinflusst konstruiert und angepasst werden können. Sobald der Deckel aus der Öffnung entnommen ist, ist der Einbauraum des Funkmoduls frei zugänglich.

Nochmals alternativ können der erfindungsgemäße Deckel und das erfindungsgemäße Funkmodul einander ergänzen. Beispielsweise kann der Deckel zum gleichzeitigen Festlegen eines Funkmoduls in der Öffnung ausgebildet sein. Der Deckel kann das Funkmodul beispielsweise formschlüssig axial und/oder winkelbezogen zur Öffnung festlegen. Bei einer bevorzugten Ausführungsform wird der Deckel durch einen Bajonettverschluss winkelbezogen definiert festgelegt, und legt der Deckel durch einen Eingriff in das Funkmodul eine Winkelposition des Funkmoduls so fest, dass die Federstifte jeweils eine vorbestimmte Anlagefläche kontaktieren. Wenn der arretierte Deckel das Funkmodul andrückend positioniert ist, wird eine Vibrationssicherheit gesteigert.

Gemäß eines weiteren Ausführungsbeispiels kann der Deckel eine längliche, rechteckförmige Außenkontur aufweisen. Die etwa rechteckförmige Außenkontur kann sowohl an Ecken, als auch an Längsseiten des Deckels mit Verrundungen versehen sein. Ein Innenabschnitt des Deckels ist entsprechend zum Wirkeingriff mit der Öffnung verrundet ausgeführt. Bei einer derartigen Ausgestaltung des Deckels ist die Greifbarkeit für den Anwender verbessert.

Unabhängig beanspruchbar ist auch ein Stecker, der zum Eingesetzt-Werden in die Öffnung des vorbeschriebenen Steuergeräts unter Herstellen der elektrischen Verbindung mit einem Kabel, und vorzugsweise auch zum vorbeschriebenen bevorzugt zerstörungsfreien Wieder-Entnommen-Werden aus der Öffnung, konfiguriert ist. Der erfindungsgemäße Stecker ist also ein Einsetzteil. Über den Stecker ist beispielsweise eine Diagnose oder eine Parametrierung in einem Produktionsprozess mit Vorteil umsetzbar. Der Stecker verfügt gemäß einer Ausführungsform über zu dem Funkmodul gleiche Kontaktelemente, wie Federstifte, zum Kontaktieren der Kontaktflächen. Die Anordnung der Kontaktelemente kann zwischen dem Funkmodul und dem Stecker gleich sein, aber der Stecker kann auch mehr oder weniger Kontaktelemente als das Funkmodul aufweisen, wobei die Anordnung der funktionsgleichen Kontaktelemente bevorzugt gleich ist. Beispielsweise kann der Stecker nur die Federstifte zum Herstellen einer elektrischen Verbindung zur seriellen Datenübertragung, nicht aber die Federstifte zum Herstellen einer elektrischen Verbindung zur Spannungsversorgung des Funkmoduls aufweisen.

Unabhängig beanspruchbar sind auch andere Einsetzteile, wie ein Speicherelement und/oder ein Erweiterungselement. Ferner kann auch ein Kommunikationselement beansprucht werden, welches eine zu Funk unterschiedliche drahtlose Übertragung, wie eine optische Übertragung, verwendet.

Zum Schutz gegen ein Manipulieren des Steuergeräts kann ein Einsetzteil, insbesondere ein Deckel ohne enthaltenes Funkmodul, mit einem Gehäuse-seitigen und/oder Einsetzteilseitigen Schloss sicherbar sein.

Unabhängig beanspruchbar sind jeweils auch ein System enthaltend ein erfindungsgemäßes Steuergerät und ein erfindungsgemäßes Funkmodul, ein System enthaltend ein erfindungsgemäßes Steuergerät und einen erfindungsgemäßen Deckel, ein System enthaltend ein erfindungsgemäßes Steuergerät, ein erfindungsgemäßes Funkmodul und einen erfindungsgemäßen Deckel, ein System enthaltend ein erfindungsgemäßes Steuergerät und einen erfindungsgemäßen Stecker, sowie ein System enthaltend ein erfindungsgemäßes Steuergerät und ein erfindungsgemäßes Einsetzteil.

Ausführungsbeispiele der Erfindung wird im Folgenden anhand schematischer Zeichnungen näher erläutert.

Es zeigen:
Figur 1 ein Steuergerät gemäß einer ersten Ausführungsform,
Figur 2 einen Schnitt durch das Steuergerät, ein Funkmodul und einen Deckel gemäß der ersten Ausführungsform,
Figur 3 eine Detailansicht einer elektrischen Verbindung zwischen dem Steuergerät und dem Funkmodul gemäß der ersten Ausführungsform,
Figur 4 eine Ansicht einer Elektronik in dem Steuergerät gemäß der ersten Ausführungsform,
Figur 5 ein Steuergerät gemäß einer zweiten Ausführungsform, und
Figur 6 einen Schnitt durch das Steuergerät, das Funkmodul und den Deckel gemäß der zweiten Ausführungsform.

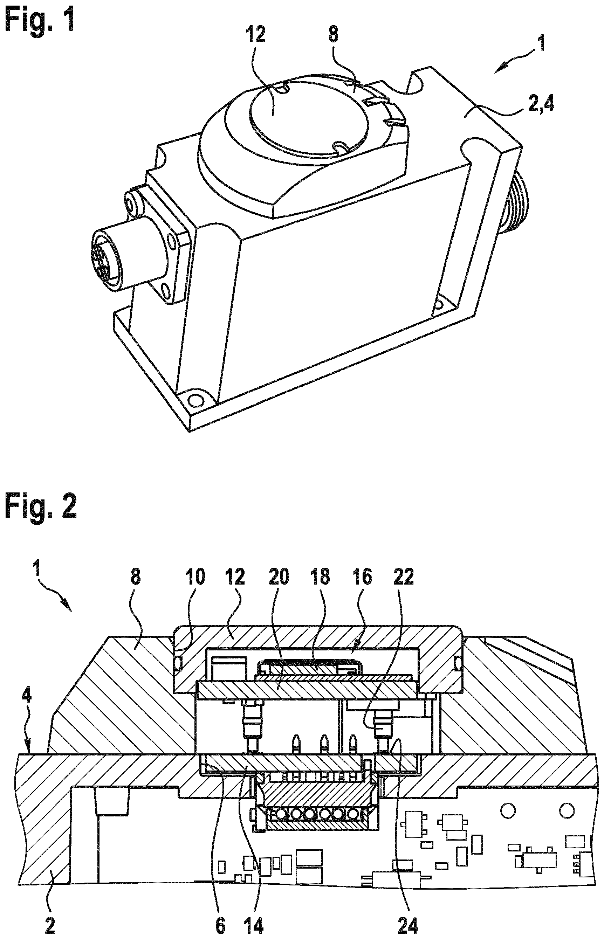

Das in Figur 1 dargestellte, erfindungsgemäße Steuergerät 1 enthält eine Elektronik, die in einem metallischen Gehäuseabschnitt 2 untergebracht ist. Der metallische Gehäuseabschnitt 2 weist eine Oberseite 4 auf. Über einer Ausnehmung 6 in der Oberseite 4 des metallischen Gehäuseabschnitts 2 ist eine Kappe 8 angeordnet, welche ein Gehäuseabschnitt ist. In dieser Kappe 8 ist wiederum eine Öffnung 10 eingebracht, welche mit einem erfindungsgemäßen Deckel 12 verschlossen. Die Verbindung zwischen Kappe 8 und Deckel 12 erfolgt über einen Schraubverschluss oder eine Art Bajonettverschluss. Die Kappe 8 und der Deckel 12 sind aus einem funkwellendurchlässigen Kunststoff gebildet.

Gemäß der Schnittdarstellung der Figur 2 ist auf der Oberseite 4 des metallischen Gehäuseabschnitts 2 die Kappe 8 abschließend aufgebracht. An der Oberseite 4 des metallischen Gehäuseabschnitts 2 ist mittig in Figur 2 erkennbar, dass die Ausnehmung 6 den metallischen Gehäuseabschnitt 2 unterbricht. Eingebettet in diese Ausnehmung 6 ist eine Platine 14 eingelegt. In der Öffnung 10 angeordnet befindet sich ein als Ganzes mit 16 bezeichnetes Bluetooth-Modul, welches ein erfindungsgemäßes Funkmodul ist. Das Bluetooth-Modul 16 enthält einen Bluetooth-Chip 18, welcher auf einem kreisförmig an die Form der Öffnung 10 angepassten Träger 20 aufgebracht ist. An einer der Platine 14 zugewandten Seite kragen Federstifte 22 von dem Träger 20 aus. Die Federstifte 22 sind dabei Kontaktelemente des Bluetooth-Moduls 16.

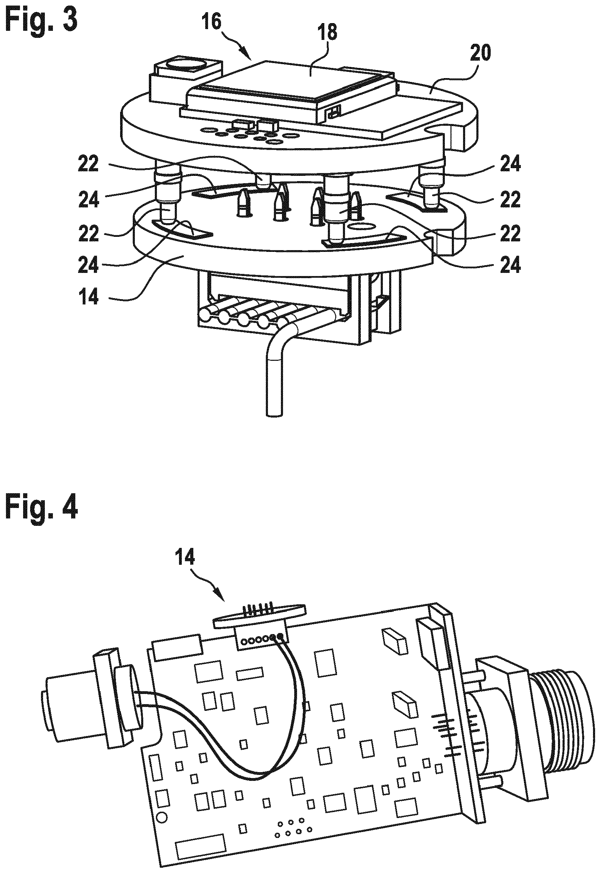

In Figur 3 wird die Kontaktierung der ebenfalls kreisförmigen Platine 14 mit dem Bluetooth-Modul 16 deutlich. Die den Träger 20 durchdringenden Federstifte 22 sind mit ringsegmentförmigen Kontaktflächen 24 der Platine 14 verbunden.

Bei dem vorliegenden Ausführungsbeispiel ist das Bluetooth-Modul 16 derart angeordnet, dass es sich innerhalb der Kappe 8 aber deutlich außerhalb des metallischen Gehäuseabschnitts 2 befindet. Aus einer derartigen Anordnung resultiert eine hohe Signalstärke, die nicht oder zumindest wenig durch den metallischen Gehäuseabschnitt 2 beeinflusst wird. Darüber hinaus ist ein Austausch oder ein Wechsel des Bluetooth-Moduls 16 durch die Anordnung außerhalb des metallischen Gehäuses 2 vereinfacht. Durch Entfernen des Deckels 12 von der Kappe 8 kann man direkt auf das Bluetooth-Modul 16 zugreifen. Das Bluetooth-Modul 16 lässt sich so einfach von der Platine 14 aus der Öffnung hinaus aus der Kappe 8 entnehmen.

Wie in der Fig. 4 gezeigt ist, umfasst die Elektronik eine Vielzahl elektronischer Komponenten, welche mit der Platine beispielsweise über eine interne Verkabelung verbunden sind.

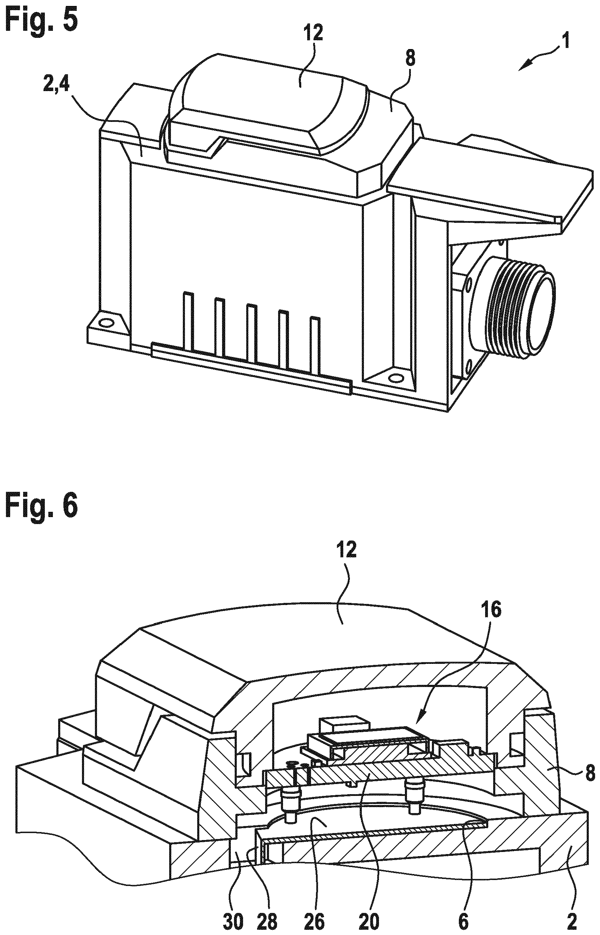

Figur 5 zeigt ein Steuergerät 1 in einem zweiten Ausführungsbeispiel. Eine Grundform des Gehäuses 2 ist gegenüber dem vorhergehenden Ausführungsbeispiel weitestgehend unverändert, wobei die Kappe 8 und der Deckel 12 eine geänderte Ausgestaltung haben. Entlang einer Längsrichtung des Gehäuses 2 ist die Kappe 8 an einer Seite 4 länglich entlang dieser Längsrichtung ausgebildet. Der Deckel 12 ist entsprechend der Kappe 8 ebenfalls länglich ausgebildet und weist eine rechteckförmige Außenkontur mit abgerundeten Ecken und Seiten auf. Umlaufend kann in einer Verrundung der von dem Gehäuse 2 abgewandten Seite des Deckels 12 eine Art Leuchtband (nicht gezeigt) eingebracht sein, das ein optisches Signal, beispielsweise zum Status der Steuerelektronik, an den Anwender abgibt.

Figur 6 zeigt eine Schnittdarstellung des zweiten Ausführungsbeispiels gezeigt. In der Ausnehmung 6 des metallischen Gehäuseabschnitts 2 ist eine Kontaktplatte 26 angeordnet. Eine derartige Kontaktplatte 26 kann beispielsweise plattenförmig, fachsprachlich als "Flexprint" Platine bezeichnet, ausgebildet sein. Gegenüber dem ersten Ausführungsbeispiel ist die Ausnehmung 6 nicht zentral für eine Steckverbindung gegenüber dem metallischen Gehäuseabschnitt 2 durchbrochen, sondern weist eine in einem Randbereich angeordnete Öffnung 30 auf, die derart klein ausgebildet ist, dass ein Anschlusskabel 28 durch diese Öffnung 30 in den metallischen Gehäuseabschnitt geführt werden kann. Dieses Anschlusskabel 28 kann als "Flexprint" Kabel ausgeführt sein. Die Kontaktplatte 26 hat im vorliegenden Ausführungsbeispiel die Funktion der Platine 14 des ersten Ausführungsbeispiels. Demgemäß ist die Kontaktplatte 26 kreisrund ausgeführt. Die Öffnung 10 der Kappe 8, der Träger 20, der das Bluetooth-Modul 16 trägt und eine Innenkontur des Deckels 12 sind in diesem Ausführungsbeispiel ebenfalls kreisförmig oder verrundet ausgeführt.

Selbstverständlich ist die zweite Ausführungsform mit der ersten Ausführungsform kombinierbar, so dass auch die Kontaktplatte 26 an Stelle der Platine 14 eingesetzt werden kann und umgekehrt.

Gemäß einer weiteren, nicht gezeigten Ausführungsform, können die Kontaktflächen 24 der Platine 14, nachdem das Bluetooth-Modul 16 aus der Öffnung 10 entnommen wurde, als Schnittstelle für eine drahtgebundene Diagnose- oder Serviceeinheit genutzt werden. Ein derartiger Stecker wäre ebenfalls kreisförmig ausgeführt, so dass seine Grundfläche, sowie seine Kontakteinheiten, denen des Trägers 20 bzw. den Federstiften 22 entsprechen würde.

Offenbart ist ein elektronisches Steuergerät 1 mit einem Gehäuse 2, 8, wobei ein Funkmodul 16, wie ein Bluetooth-Modul, in eine Öffnung 10 des Gehäuses 2, 8 einsetzbar und vorzugsweise wieder entnehmbar ist. Ferner ein in die Öffnung 10 einsetzbares Funkmodul 16, ein darin einsetzbarer Deckel 12 und ein darin einsetzbarer Stecker.

## Patentansprüche

1. Elektronisches Steuergerät mit einer Steuerelektronik, die in einem Gehäuse (2, 8) angeordnet ist, **dadurch gekennzeichnet, dass** ein Funkmodul (16) in eine Öffnung (10) an einer Seite (4) des Gehäuses (2, 8) unter Herstellen einer elektrischen Verbindung zu der Steuerelektronik einsetzbar ist.

2. Steuergerät nach Anspruch 1, **dadurch gekennzeichnet, dass** das Funkmodul (16) aus der Öffnung (10) wieder entnehmbar ist.

3. Steuergerät nach einem der vorhergehenden Ansprüche, **dadurch gekennzeichnet**, es durch die Öffnung (10) kontaktierbare Kontaktflächen (24) aufweist.

4. Steuergerät nach Anspruch 3, **dadurch gekennzeichnet, dass** die Kontaktflächen (24) als Ringsegmente ausgeführt sind.

5. Steuergerät nach Anspruch 3, **dadurch gekennzeichnet, dass** eine Kontaktplatte (26) die Kontaktflächen (24) flächig ausbildet.

6. Steuergerät nach einem der vorhergehenden Ansprüche, **dadurch gekennzeichnet, dass** das Gehäuse (2, 8) zumindest einen Abschnitt (2) aus einem metallischen Werkstoff und einen an einen Einbauraum für das Funkmodul (16) angrenzenden Abschnitt (8) aus einem funkwellendurchlässigen Material aufweist.

7. Steuergerät nach Anspruch 5, **dadurch gekennzeichnet, dass** das funkwellendurchlässige Material den Einbauraum etwa hemisphärisch umgibt.

8. Steuergerät nach einem der vorhergehenden Patentansprüche, **dadurch gekennzeichnet, dass** an der Öffnung (10) ein zum Arretieren eines Einsetzteils (16) konfigurierter Drehverschluss vorgesehen ist.

9. Steuergerät nach einem der vorhergehenden Ansprüche, **dadurch gekennzeichnet, dass** es zum Ansteuern eines Hydraulikventils konfiguriert ist.

10. Funkmodul für ein Steuergerät (1), **dadurch gekennzeichnet, dass** es zum Eingesetzt-Werden in die Öffnung (10) des Steuergeräts (1) gemäß einem der vorstehenden Ansprüche unter Herstellen der elektrischen Verbindung konfiguriert ist.

11. Funkmodul nach Anspruch 9, **dadurch gekennzeichnet, dass** es zu den Kontaktflächen (24) des Steuergeräts (1) nach einem der Ansprüche 2 bis 9 korrespondierende Kontaktelemente (22) enthält.

12. Funkmodul nach Anspruch 10, **dadurch gekennzeichnet, dass** die Kontaktelemente (22) zur ausgleichenden Anlage vorgespannt teleskopierbar ausgebildete Federstifte (24) sind.

13. Deckel, **dadurch gekennzeichnet, dass** er zum dichtenden Verschließen der Öffnung (10) eines Steuergeräts (1) gemäß einem der Ansprüche 1 bis 8 ausgebildet ist.

14. Deckel nach Anspruch 12, **dadurch gekennzeichnet, dass** er zum Festlegen eines Funkmoduls (16) gemäß einem der Ansprüche 9 bis 11 in der Öffnung (10) ausgebildet ist.

15. Deckel nach Anspruch 13, **dadurch gekennzeichnet, dass** er einen etwa kreisrunden oder verrundeten Innenabschnitt hat in den das Funkmodul (16) einsetzbar ist, und eine längliche, etwa rechteckige Außenkontur aufweist.

16. Stecker für ein Steuergerät (1), **dadurch gekennzeichnet, dass** er zum Eingesetzt-Werden in die Öffnung (10) des Steuergeräts (1) gemäß einem der Ansprüche 1 bis 8 unter Herstellen der elektrischen Verbindung zu einem Kabel konfiguriert ist.
